# EUROPÄISCHE PATENTSCHRIFT

(11) **EP 2 624 291 B1**
(45) Veröffentlichungstag und Bekanntmachung des Hinweises auf die Patenterteilung: **13.10.2021**
(21) Anmeldenummer: 12195511.6
(22) Anmeldetag: 04.12.2012
(51) Int. Cl.: H01L 21/683

(54) **Vorrichtung zum Bearbeiten eines Substrats und Verfahren hierzu**
Device for processing a substrate and method for this
Dispositif de traitement d'un substrat et procédé pour ce faire

(30) Priorität: 01.02.2012 DE 102012100825
(43) Veröffentlichungstag der Anmeldung: 07.08.2013
(73) Patentinhaber: Obducat Europe GmbH, 78315 Radolfzell (DE)
(72) Erfinder: Muffler, Pirmin, 78359 Nenzingen (DE)
(74) Vertreter: Patentanwälte und Rechtsanwalt Weiß, Arat & Partner mbB

(56) Entgegenhaltungen:
- EP-A1- 0 611 273
- WO-A1-02/47155
- US-A- 4 588 343
- US-A1- 2002 134 512
- US-A1- 2009 277 379
- None

## Beschreibung

### TECHNISCHES GEBIET

Die Erfindung betrifft eine Vorrichtung zum Bearbeiten, insbesondere Ätzen und/oder Entwickeln von Substraten, insbesondere von Wafern nach dem Oberbegriff des Anspruchs 1, sowie ein Verfahren nach dem Oberbegriff des Anspruchs 7.

### STAND DER TECHNIK

Aus dem Stand der Technik sind vielfältige, unterschiedliche Vorrichtungen zum Bearbeiten von Substraten bekannt. Insbesondere in der Halbleitertechnik sind Dreh-, bzw. Spinnbelacker zum Aufbringen von Fotolack auf Substrate bekannt. Diese Dreh-, bzw. Spinnbelacker werden auch als "Coater" bezeichnet. Als Substrate dienen Wafer oder Glasscheiben od. dgl. Neben diesen sog. Coatern sind auch Vorrichtungen zum Bearbeiten, insbesondere

Ätzen und/oder Entwickeln von Substraten aus dem Stand der Technik bekannt.

In diesem Zusammenhang wird insbesondere auf die EP 1 743 220 A1 verwiesen. Die im Stand der Technik beschriebene Vorrichtung zum Drehbelacken von Substraten beschreibt ein Spinnbelacker, welcher einen drehbaren Substratteller zur horizontalen Auflage eines Substrats, aufweist. Das Bearbeitungsmedium wird durch Drehen des Substrattellers verteilt. Ein besonderes Problem ist, dass das Bearbeitungsmedium auch auf die Rückseite des zu behandelnden Substrates dringt und diese verändert. Insbesondere bei zweiseitigen Wafern führt dies zur Beschädigung der Rückseite.

Ein weiterer, berührungsloser Substratteller ist in der EP 0 611 273 A1 gezeigt.

### AUFGABE DER ERFINDUNG

Aufgabe der Erfindung ist es, eine Vorrichtung zum Bearbeiten, insbesondere Ätzen und/oder Entwickeln von Substraten, insbesondere von runden Wafern zu schaffen um einen Wafer so zu bearbeiten, dass seine Rückseite nicht beschädigt und/oder verschmutzt wird, sowie ein Verfahren hierzu.

Zur Lösung der Aufgabe führen die Merkmale der Ansprüche 1 und 7. Erfindungsgemäß umfasst die Vorrichtung zum Bearbeiten, insbesondere Ätzen und/oder Entwickeln von Substraten, insbesondere von runden Wafer, einen Drehteller, der einen Venturi-Spalt aufweist. Vorzugsweise wird durch den Venturi-Spalt Druckluft oder ein anderes Medium ausgebracht. Dadurch ergeben sich mehrere Vorteile. Der erste Vorteil ist, dass dadurch das Substrat nach dem Venturi-Prinzip angesaugt wird, auf dem Drehteller gehalten wird und trotz der Rotation des Drehtellers nicht weggeschleudert wird. Ein weiterer Vorteil ist, dass die Rückseite sauber bleibt und das Behandlungsmedium nicht auf die Rückseite laufen kann um diese zu verschmutzen oder zu beschädigen. Dies ist besonders von Vorteil für doppelseitig beschichtete, bzw. bearbeitete Substrate.

Zweckmässigerweise weist der Venturi-Spalt eine Spaltgrösse von einem 0,01 mm bis 0,1mm, bevorzugt 0,58 mm, auf. Grundsätzlich ist die Spaltgrösse abhängig von der zu bearbeitenden Substratdicke und -grösse.

In typischen Ausführungsbeispielen umfasst die Vorrichtung eine Druckluftquelle. Dadurch ergibt sich der Vorteil, dass der Venturi-Spalt mit Druckluft oder Druckmedium beaufschlagt werden kann. Besonders bevorzugt ist die Druckmedienquelle geeignet einen Überdruck von 4 bis 8 Bar, bevorzugt 6 Bar zu erzeugen.

Bevorzugt umfasst die Vorrichtung definierte Kanten um eine definierte Druckverteilung, insbesondere im Venturi-Spalt zu erreichen. Besonders bevorzugt sind die Kanten dem Venturi-Spalt vorgeschaltet.

In typischen Ausführungsbeispielen umfasst die Vorrichtung zumindest ein Loch. Bevorzugt ist das zumindest eine Loch in einem mittleren Bereich des Drehtellers angeordnet, der einem Substrat zugewandt ist. Bevorzugt sind mehrere Löcher in der Oberfläche angeordnet. Dadurch ergibt sich der Vorteil, dass verhindert wird, dass zwischen dem Drehteller und einem mittleren Bereich des Substrats ein Unterdruck bzw. ein Vakuum entsteht. Dies ist vorteilhaft, da verhindert wird, dass sich das Substrat in dem mittleren Bereich durchbiegt oder auf eine andere Weise verformt.

Erfindungsgemäß weist der Drehteller eine Schalenform auf. Dadurch ergibt sich der Vorteil, dass der Drehteller sehr robust ist und einfach und kostengünstig herstellbar ist.

In typischen Ausführungsbeispielen weist die Vorrichtung einen Diffusor auf. Bevorzugt ist der Diffusor in einen Innenraum des Drehtellers eingesetzt. Besonders bevorzugt bildet der Diffusor mit dem Drehteller den Venturi-Spalt aus. Noch bevorzugter bildet der Diffusor mit seiner Oberfläche zumindest teilweise eine Fläche aus, in der sich ein Vakuum zwischen dem Wafer und der Oberfläche ausbilden kann.

Besonders bevorzugt bildet der Diffusor mit seiner Unterseite eine Kante aus, die für eine definierte Druckverteilung des Druckmediums zwischen der Oberfläche des Drehtellers und der Unterseite des Diffusors sorgt.

Besonderes bevorzugt umfasst die Vorrichtung, insbesondere der Drehteller eine Mehrzahl, vorzugsweise drei oder vier Pins. Die Pins führen vorteilhaft dazu, dass der Wafer in eine vordefinierte Position zwischen den Pins rutscht. Bei Aufliegen auf einem der Pins wird dies durch eine Sensoreinheit erkannt und der Bearbeitungsvorgang wird nicht in Gang gesetzt.

In typischen Ausführungsbeispielen umfasst die Vorrichtung einen Drehteller, der eine Mehrzahl von Nuten aufweist. Bevorzugt sind die Nuten an einer Umfangskante des Drehtellers angeordnet. Vorzugsweise sind die Nuten so angeordnet, dass der Wafer oder das Substrat, wenn er korrekt liegt, über die Nuten ragt.

In typischen Ausführungsbeispielen umfasst die Vorrichtung einen Greifer. Bevorzugt umfasst der Greifer eine Mehrzahl von Hebepins. Bevorzugt sind die Hebepins des Greifers im gleichen Winkelabstand zu den Nuten am Drehteller angeordnet. Bevorzugt sind die Hebepins des Greifers auf einem Durchmesser angeordnet, der einem Durchmesser, auf dem die Nuten des Drehtellers angeordnet sind, entspricht. Dadurch ergibt sich der Vorteil, dass mit den Hebepins des Greifers in die Nuten des Drehtellers gegriffen werden kann, sodass der Wafer oder das Substrat auf den Hebepins des Greifers zu liegen kommt.

Des Weiteren ist vorteilhaft, dass der Greifer auch zum Ablegen des Wafers auf dem Teller verwendet werden kann, ohne den Greifer zu beschädigen.

In typischen Ausführungsbeispielen ist der Drehteller so ausgebildet, dass ein Medien- oder Luftstrom, der aus dem Venturi-Spalt austritt in einem Bereich unterhalb einer Oberfläche des Drehteller geleitet wird. Dadurch ergibt sich der Vorteil, dass eine bessere Beschichtung erreicht wird. Dies ist möglich, weil eine Strömung über einer Oberfläche und damit über einem Substrat vermieden beziehungsweise reduziert wird. Durch das Reduzieren beziehungsweise Vermeiden einer Strömung über dem Substrat ein besserer Beschichtungsauftrag erreicht. Zunächst wird beim Auftragen das Beschichtungsmedium weniger verwirbelt. Weiterhin ist auch die aufgebrachte Beschichtung keiner Strömung ausgesetzt ist, wodurch ein besseres Trocknungsergebnis erreicht wird. Zuletzt wird durch die vermiedene beziehungsweise reduzierte Strömung über der Oberfläche des Substratstellers beziehungsweise des Substrats das Aufwirbeln von Schmutz oder Partikeln vermieden, die sich auf die frische Beschichtung legen könnten.

Erfindungsgemäß weist der Drehteller dazu eine Fase auf. Dabei ist die Fase an einer oberen Umfangskante eines Unterteils des Drehtellers angeordnet.

Vorzugsweise weist die Fase eine Breite von 0,5 mm bis10 mm, insbesondere eine Breite von 1 mm bis 5 mm, vorzugsweise 3 mm auf. Vorzugsweise weist die Fase eine Höhe von 0,5 mm bis10 mm, insbesondere eine Breite von 1 mm bis 5 mm, vorzugsweise 3 mm auf.

Zweckmässigerweise beträgt ein Winkel, der zwischen der Achse einer Oberfläche des Drehtellers und der Achse einer Oberfläche der Fase ausgebildet wird, zwischen 5° und 85°, vorzugsweise 20 bis 50°, insbesondere 48°.

Gesondert wird Schutz beansprucht für ein Verfahren zum Bearbeiten, insbesondere Ätzen und/oder Entwickeln von Substraten, insbesondere von runden Wafer, mit einer Vorrichtung gemäß Anspruch 1 und mit den Schritten: Drehen des Drehtellers, Aufbringen eines Bearbeitungsmediums auf den Drehteller, Abnehmen eines Substrates.

In typischen Ausführungsbeispielen wird zum Auflegen des Substrats ein Schieber positioniert. Dabei liegt das Substrat auf dem Schieber. Vorzugsweise ist der Schieber ein linear bewegbares Element. Zweckmässigerweise wird der Schieber so verfahren, dass das Substrat über dem Drehteller positioniert ist. Anschliessend wird der Greifer so unter dem Schieber und das Substrat positioniert, dass das Substrat auf den drei Hebepins des Greifers aufliegt. Zweckmässigerweise wird der Schieber unter dem Substrat entfernt, vorzugsweise durch eine lineare Bewegung. Bevorzugt wird in einem anschliessenden Schritt das Substrat auf dem Drehteller abgelegt, insbesondere zwischen den Pins des Drehtellers. Vorzugsweise erfolgt das Ablegen durch eine Relativbewegung zwischen dem Drehteller und dem Greifer entlang einer Drehachse des Drehtellers, wobei die Hebepins des Greifers durch die Nuten des Drehtellers fahren.

In typischen Ausführungsbeispielen erfolgt das Abnehmen eines Substrates analog. Vorzugsweise wird dazu ein Greifer unter dem Substrat an dem Drehteller positioniert, so dass die Hebepins des Greifers von unten in die Nuten des Drehtellers greifen können.

Durch eine Relativbewegung zwischen dem Drehteller und dem Greifer entlang einer Drehachse des Drehtellers greifen die Hebepins des Greifers in die Nuten des Drehtellers, sodass das Substrat auf drei Punkten des Greifers aufliegt, so dass das Substrat von dem Drehteller abgehoben wird.

.Besonders bevorzugt wird der Schieber unter dem Substrat positioniert und der Greifer unter dem Substrat entfernt. Anschliessend wird das Substrat mit dem Schieber weg vom Drehteller verfahren.

Mit dem Begriff "Relativbewegung" ist gemeint, dass sowohl der Greifer entlang der Drehachse in Richtung des Drehtellers bewegt werden kann, sowie auch der Drehteller entlang der Drehachse durch eine Hubbewegung in Richtung des Greifers bewegt werden kann.

### FIGURENBESCHREIBUNG

Weiter Vorteile, Merkmale und Einzelheiten der Erfindung ergeben sich aus der nachfolgenden Beschreibung bevorzugter Ausführungsbeispiele, sowie anhand der Zeichnungen; diese zeigt in
Figur 1 eine schematische Darstellung eine perspektivischer Ansicht eines Drehtellers einer erfindungsgemässen Vorrichtung;
Figur 2 eine schematische Darstellung einer geschnittenen Seiteansicht des Drehtellers nach Figur 1 ;
Figur 4 eine schematische Darstellung einer perspektivischen Ansicht eines Greifers für eine erfindungsgemässe Vorrichtung;

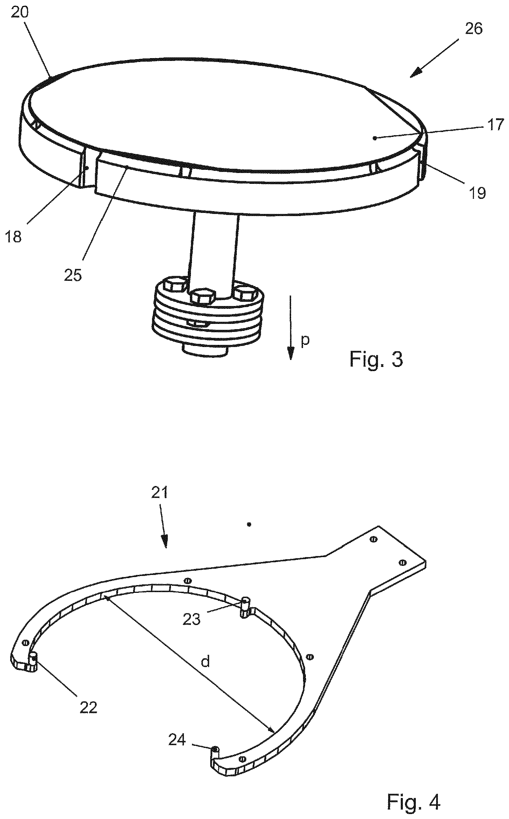

Figur 3 eine schematische Darstellung einer perspektivischen Ansicht eines weiteren Ausführungsbeispiels eines Drehtellers für eine erfidungsgemässe Vorrichtung mit einem Wafer;

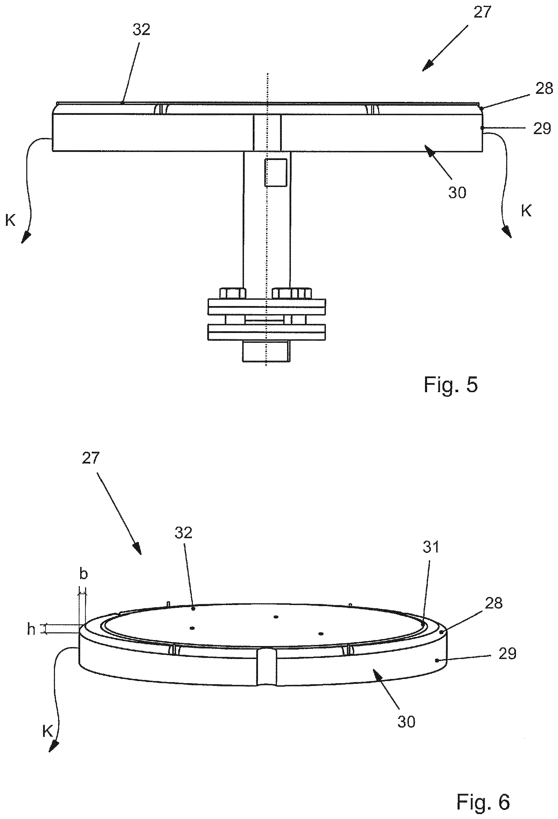

Figur 5 eine schematische Darstellung einer Seitenansicht eines weiteren Ausführungsbeispiels eines Drehtellers einer erfindungsgemässen Vorrichtung;
Figur 6 eine schematische Darstellung einer perspektivischen Ansicht des Drehtellers nach Figur 5.

### AUSFÜHRUNGSBEISPIEL

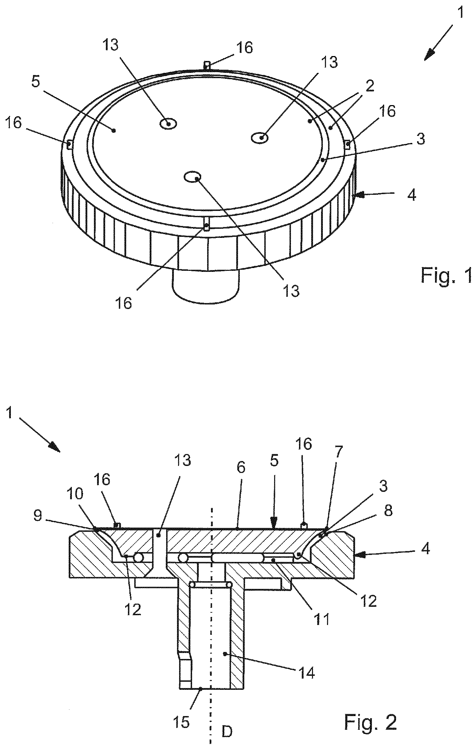

Figur 1 zeigt einen Drehteller 1 für eine erfindungsgemässe Vorrichtung. Der Drehteller 1 weist eine Oberfläche 2 für ein Substrat, insbesondere einen Wafer auf. Der Drehteller 1 weist eine Kreisform auf. Des Weiteren weist der Drehteller 1 einen Venturi-Spalt 3 auf. Der Venturi-Spalt 3 ist an der Oberfläche 2 des Drehtellers 1 angeordnet.

Wie in Figur 2 erkennbar, umfasst der Drehteller 1 ein schalenförmiges Unterteil 4.

In das schalenförmige Unterteil 4 des Drehtellers 1 ist ein Diffusor 5 eingesetzt. Der Diffusor 5 bildet mit seiner Oberfläche 6 einen Teil der Oberfläche 2 aus.

Der Diffusor 5 bildet mit seiner umlaufenden Kante 7 und einem inneren Rand 8 des schalenförmigen Unterteils 4 des Drehtellers den Venturi-Spalt 3 aus.

Im vorliegendem Ausführungsbeispiel weist der Venturi-Spalt eine Höhe von 0,58 mm auf. Die Höhe wird gemessen von einer Unterteiloberfläche 9 des schalenförmigen Unterteils 4 zu einer Oberkante 10 des Diffusors 5.

Der Drehteller 1 weist eine Drehachse D auf.

Der Diffusor 5 ist so in das schalenartige Unterteil 4 des Drehtellers 1 eingesetzt, dass sich zwischen dem Diffusor 5 und dem Drehteller 1 ein Spalt 11 ausbildet. In den Spalt 11 ragen definierte Kanten 12. Die Kanten 12 haben die Aufgabe für eine definierte Druckverteilung eines Druckmediums, insbesondere Druckluft, die durch den Kanal 11 in den Venturi-Spalt 3 strömt, zu sorgen. Die Kanten 12 sind an einer Unterseite des Diffusors 5 ausgebildet.

Des Weiteren umfasst der Drehteller 1 eine Mehrzahl von Löchern 13. Die Löcher 13 sind in den Diffusor 5 eingebracht.

Der Drehteller 1 weist einen Kanal 14 auf. An einem Ende 15 des Kanals 14 ist eine nicht dargestellte Druckluft- oder Druckmedienquelle angeschlossen.

Der Drehteller 1 weist eine Mehrzahl von Pins 16 auf. Diese dienen der Positionierung des Substrats bzw. des Wafers. Dadurch, dass das Substrat nur zwischen den Pins 16 zum Liegen kommt, ergibt sich der Vorteil, dass eine genau definierte Positionierung zwischen den Pins erfolgen kann. Ausserdem ist es auf diese Weise vorteilhaft durch eine nicht gezeigte Sensoreinrichtung detektierbar, ob das Substrat bzw. der Wafer in der vordefinierten Position zum Liegen gekommen ist.

Die Funktionsweise des erfindungsgemässen Drehtellers nach den Figuren 1 und 2 ist folgende:
Auf den Drehteller 1 der Figuren 1 und 2 wird ein nicht dargestelltes Substrat, insbesondere ein runder Wafer gelegt.

Über eine am Ende 15 des Kanals 14 angeschlossene Druckluftquelle wird der Drehteller 1 mit Druckluft beaufschlagt. Dabei strömt Druckluft in den Kanal 14 durch den Spalt 11 und aus dem Venturi-Spalt 3 zwischen die Unterteiloberfläche 9 des Unterteils 4 und den Wafer bzw. das Substrat. Dadurch wird nach dem Venturi-Prinzip ein Unterdruck erzeugt, der den Wafer oder das nicht dargestellte Substrat trotz einer schnellen Drehbewegung des Drehtellers 1 um die Drehachse D, auf dem Drehteller 1 hält.

Des Weiteren wird so verhindert, dass das auf einer Oberseite des Substrates aufgebrachte Behandlungsmedium, beispielsweise Ätzmittel oder Entwickler auf eine Rückseite des Mediums läuft und diese beschädigt bzw. verändert.

Durch die Löcher 13 strömt Druckluft aus dem Kanal 14 zwischen die Oberfläche 2 und das Substrat bzw. den Wafer. Dadurch, wird verhindert, dass sich in dem Bereich der Löcher 13 ein Vakuum bzw. ein Unterdruck bildet, der das Substrat nach unten durchbiegt, verformt und/oder beschädigt.

Die Figur 3 zeigt ein weiteres Ausführungsbeispiel eines Drehtellers 26 Auf diesem liegt ein Substrat 17. Im Wesentlichen ist der Drehteller 26 analog zum Drehteller 1 aufgebaut.

Weiter weist der Drehteller 26 eine Mehrzahl von Nuten 18, 19 und 20 auf. Die Nuten sind an einer Umfangskante 25 des Drehtellers 26 eingebracht und weisen eine Läge auf, die einer Höhe des Drehtellers entspricht.

Des weiteren umfasst eine erfindungsgemässe Vorrichtung einen Greifer 21, wie in Figur 4 dargestellt. Der Greifer 21 weist drei Hebepins 22, 23 und 24 auf. Die Hebepins 22 bis 24 sind auf einem Durchmesser d angeordnet. Der Durchmesser d entspricht im Wesentlichen einem Durchmesser eines Drehtellers 1 bzw. 26

Die Nuten 18, 19 und 20 sind in den gleichen Winkelabständen wie die Hebepins 22, 23 und 24 angeordnet. Vorzugsweise sind die Nuten 18, 19 und 20 ebenfalls auf dem Durchmesser d angeordnet.

Die Funktionsweise der erfindungsgemässen Vorrichtung mit einem Drehteller 26 ist folgende:
Um den Wafer 17 auf den Drehteller 26 abzulegen wird dieser mit einem nicht dargestellten Schieber in einem Abstand der mindestens der Höhe des Schiebers entspricht über den Drehteller 26 positioniert.

Dann wird der Greifer 21 unter den Wafer 17 gefahren, sodass der Wafer 17 mit seinen Rändern auf den drei Hebepins 22, 23 und 24 zu liegen kommt. Anschliessend wird über eine Relativbewegung zwischen Drehteller 26 und Greifer 21, also entweder durch Absenken des Greifers 21 in Richtung des Drehtellers 26 oder Heben des Drehtellers 26 in Richtung des Greifers 21 der Wafer 17 auf einer Oberfläche des Drehtellers 26, wie in Figur 3 gezeigt, abgelegt. Dabei gleiten die Hebepins 22, 23 und 24 durch die Nuten 18, 19 und 20 des Drehtellers 26 der Figur 3.

Der Greifer 21 wird derart gegenüber dem Drehteller 26 bewegt, dass die Hebepins 22, 23 und 24 nach unten in Pfeilrichtung P aus den Nuten 18, 19 und 20 herausgefahren werden, dann wird der Greifer 21 wieder vom Drehteller 26 entfernt.

Jetzt kann der Wafer 17 beispielsweise mit Ätzmedium oder Entwickler, bearbeitet werden.

Um den Wafer 17 vom Drehteller 26 abzunehmen wird im Wesentlichen analog zum Auflegen, aber in umgekehrter Reihenfolge verfahren.

Der Greifer 21 wird unterhalb des Drehtellers 26 an den Drehteller 26 positioniert und dann entgegen der Pfeilrichtung P mit den Hebepins 22, 23 und 24 in die entsprechenden Nuten 18, 19 und 20 bewegt. Dadurch liegt der Wafer 17 auf die Oberseite der Hebepins 22, 23 und 24 wird mit dem Greifer '21 weg vom Drehteller 26 bewegt.

Anschliessend wird der nicht dargestellte Schieber unter den Wafer 17 und der Wafer 17 mit dem Schieber aus dem Bereich des Drehteller 26 entfernt.

Figur 5 zeigt einen weiteren Drehteller 27. Der Drehteller 27 ist im Wesentlichen analog zu einem der Drehteller 1 oder 26 ausgebildet. Der Drehteller 27 umfasst eine Fase 28. Dies ist auch in der perspektivischen Darstellung des Drehteller 27 in Figur 6 erkennbar.

Mit der Fase 28 wurde eine obere Kante an einem Umfang 29 des Drehtellers 27 entfernt.

Die Fase 28 ist in einem Unterteil 30 angebracht. Das Unterteil 30 ist im Wesentlichen analog zu dem Unterteil 4 ausgebildet.

Durch die Fase 28 ergibt sich der Effekt, dass ein Medium, insbesondere Luft, aus einem Venturi-Spalt 31 ausgeblasen wird und in Pfeilrichtung K abgeleitet wird. Dies ist vorteilhaft, weil das Medium, insbesondere in die Luft in einen Bereich unterhalb des Drehtellers 27 geleitet wird. Dadurch ergibt sich der Vorteil, dass ungewollte Luftverwirbelungen über einer Oberfläche 32 des Drehtellers 27 vermieden und/oder reduziert wird. Dies ist vorteilhaft, weil dadurch eine bessere Beschichtung eines Substrats erreicht wird. Dies ist möglich, weil bei einer geringeren Strömung über der Oberfläche des Drehteller beziehungsweise des Substrats die Beschichtung keiner Strömung ausgesetzt ist und auch weniger Partikel von einer Luftströmung auf die Beschichtung aufgebracht werden können.
Bei dem Drehteller 27 wird eine Strömung, die aus dem Venturi-Spalt 31 austritt, in Richtung einer Neigung der Fase 28 oder steiler von einer Oberfläche 32 des Drehtellers 27 in einen Bereich unterhalb einer Oberfläche des Drehtellers 27 weggeleitet.

Im vorliegenden Ausführungsbeispiel weist die Fase 28 eine Breite b von 0,5 mm bis10 mm, insbesondere eine Breite von 1 mm bis 5 mm, vorzugsweise 3 mm auf. Vorzugsweise weist die Fase 28 eine Höhe h von 0,5 mm bis10 mm, insbesondere eine Breite von 1 mm bis 5 mm, vorzugsweise 3 mm auf.

**Bezugszeichenliste**

| | | | | | |
|---|---|---|---|---|---|
| 1 | Drehteller | 34 | | 67 | |
| 2 | Oberflächen | 35 | | 68 | |
| 3 | Venturi-Spalt | 36 | | 69 | |
| 4 | Unterteil | 37 | | 70 | |
| 5 | Diffusor | 38 | | 71 | |
| 6 | Diffusoroberfläche | 39 | | 72 | |
| 7 | Kante | 40 | | 73 | |
| 8 | Innenrand | 41 | | 74 | |
| 9 | Unterteiloberfläche | 42 | | 75 | |
| 10 | Oberkante | 43 | | 76 | |
| 11 | Spalt | 44 | | 77 | |
| 12 | Kanten | 45 | | 78 | |
| 13 | Loch | 46 | | 79 | |
| 14 | Kanal | 47 | | | |
| 15 | Ende | 48 | | | |
| 16 | Pin | 49 | | | |
| 17 | Substrat | 50 | | | |
| 18 | Nut | 51 | | | |
| 19 | Nut | 52 | | | |
| 20 | Nut | 53 | | D | Drehachse |
| 21 | Greifer | 54 | | d | Durchmesser |
| 22 | Hebepin | 55 | | p | Pfeilrichtung |
| 23 | Hebepin | 56 | | K | Pfeilrichtung |
| 24 | Hebepin | 57 | | b | Breite |
| 25 | Aussenkante | 58 | | H | Höhe |
| 26 | Drehteller | 59 | | | |
| 27 | Drehteller | 60 | | | |
| 28 | Fase | 61 | | | |
| 29 | Umfang | 62 | | | |
| 30 | Unterteil | 63 | | | |
| 31 | Venturi-Spalt | 64 | | | |
| 32 | Oberfläche | 65 | | | |
| 33 | | 66 | | | |

## Patentansprüche

1. Vorrichtung zum Bearbeiten, insbesondere Ätzen und/oder Entwickeln von Substraten (17), insbesondere Wafern, mit einem Drehteller (27), wobei der Drehteller (27) einen Venturi-Spalt (31) aufweist und der Drehteller (27) eine Schalenform aufweist wobei der Drehteller (27) eine Fase (28) umfasst, wobei die Fase (28) in einem Unterteil (30) angebracht ist,
**dadurch gekennzeichnet,**
**dass** die Fase (28) an einer oberen Umfangskante des Drehtellers (27) angebracht ist.

2. Vorrichtung nach Anspruch 1, **gekennzeichnet durch** eine Druckmediumquelle.

3. Vorrichtung nach eine der vorhergehenden Ansprüche, **gekennzeichnet durch** zumindest ein Loch (13), das geeignet ist zum Auslassen eines Druckmediums.

4. Vorrichtung nach einem der vorhergehenden Ansprüche, **gekennzeichnet, durch** einen Diffusor (5), der in den Drehteller (1) eingesetzt, ist und den Venturi-Spalt (3) ausbildet.

5. Vorrichtung nach einem der vorhergehenden Ansprüche, **dadurch gekennzeichnet, dass** der Drehteller (26) an seiner Aussenkante (25) eine Mehrzahl von Nuten (18, 19, 20) aufweist.

6. Vorrichtung nach einem der vorhergehenden Ansprüche, **gekennzeichnet durch** einen Greifer (21), mit einer Mehrzahl von Hebepins (22, 23, 24).

7. Verfahren für eine Vorrichtung nach den Ansprüchen 1 bis 6 **gekennzeichnet durch** die Schritte;
- Auflegen eines Substrats (17) auf den Drehteller (26), - Beaufschlagen des Venturi-Spalts (3) mit einem Druckmedium,
- Drehen des Substrats (17) mittels des Drehtellers (26),
- Aufbringen eines Bearbeitungsmediums auf das Substrat (17),
- Abnehmen des Substrats (17).

8. Verfahren nach Anspruch 7, **dadurch gekennzeichnet dass** der Schritt Auflegen des Substrats (17) folgende Schritte umfasst:
- Positionieren des Substrats (17) auf einem Schieber;
- Verfahren des Schiebers, so dass das Substrat (17) über dem Drehteller (26) positioniert ist,
- Positionieren eines Greifers (21) unter dem Substrat (17), so dass das Substrat (17) auf drei Hebepins (22, 23, 24), des Greifers (21) aufliegt,
- Entfernen des Schiebers unter dem Substrat (17),
- Ablegen des Substrats (17) auf dem Drehteller (26), durch eine Relativbewegung zwischen dem Drehteller (26) und dem Greifer (21) entlang einer Drehachse (D) des Drehtellers (26), wobei die Hebepins (22, 23, 24) des Greifers (21) in die Nuten (18, 19, 20) des Drehtellers (26) greifen.

9. Verfahren nach Anspruch 7, **dadurch gekennzeichnet, dass** der Schritt Abnehmen eines Substrats (17) folgende Schritte umfasst:
- Positionieren eines Greifers (21) unter dem Substrat (17) an dem Drehteller (26),
- Ausführen einer Relativbewegung zwischen dem Drehteller (26)und dem Greifer (21) entlang einer Drehachse (D) des Drehtellers (26), wobei die Hebepins (22, 23, 24) des Greifers (21) in die Nuten (18, 19, 20) des Drehtellers (26) greifen, so dass das Substrat (17) auf drei Punkten, des Greifers (21) aufliegt,
- Positionieren des Schiebers unter dem Substrat (17),
- Entfernen des Greifers (21) unter dem Substrat (17),
- Verfahren des Schiebers mit dem Substrat (17).

## Claims

1. Device for machining, in particular etching and/or developing, substrates (17), in particular wafers having a turntable (27), wherein the turntable (27) has a Venturi gap (31) and the turntable (27) has a dish shape, wherein the turntable (27) has a chamfer (28), wherein the chamfer (28) is mounted in a bottom part (30)
**characterized in that**
the chamfer (28) is mounted at an upper circumferential edge of the turntable (27).

2. Device according to claim 1, **characterized by** a pressure medium source.

3. Device according to one of the preceding claims, **characterized by** at least one hole (13), which is suitable for allowing out a pressure medium.

4. Device according to one of the preceding claims, **characterized by** a diffuser (5), which is inserted into the turntable (1) and forms the Venturi gap (3).

5. Device according to one of the preceding claims, **characterized in that** the turntable (26) has a plurality of grooves (18, 19, 20) on its outer edge (25).

6. Device according to one of the preceding claims, **characterized by** a gripper (21) having a plurality of lifting pins (22, 23, 24).

7. Method for a device according to claims 1 to 6, **characterized by** the following steps:
- placement of a substrate (17) on the turntable (26),
- supplying a Venturi gap (3) with a pressure medium,
- rotation of the substrate (17) by means of the turntable (26),
- application of a machining medium to the substrate (17),
- removal of the substrate (17).

8. Method according to claim 7, **characterized in that** the step of placing the substrate (17) comprises the following steps:
- positioning of the substrate (17) on a slide;
- movement of the slide so that the substrate (17) is positioned over the turntable (26),
- positioning of a gripper (21) under the substrate (17) so that the substrate (17) rests on three lifting pins (22, 23, 24) of the gripper (21),
- removal of the slide from under the substrate (17),
- deposition of the substrate (17) on the turntable (26) by means of a relative movement between the turntable (26) and the gripper (21) along an axis of rotation (D) of the turntable (26), wherein the lifting pins (22, 23, 24) of the gripper (21) engage in the grooves (18, 19, 20) of the turntable (26).

9. Method according to claim 7, **characterized in that** the step of removing a substrate (17) comprises the following steps:
- positioning of a gripper (21) under the substrate (17) on the turntable (26),
- execution of a relative movement between the turntable (26) and the gripper (21) along an axis of rotation (D) of the turntable (26), wherein the lifting pins (22, 23, 24) of the gripper (21) engage in the grooves (18, 19, 20) of the turntable (26), with the result that the substrate (17) rests on three points of the gripper (21),
- positioning of the slide under the substrate (17),
- removal of the gripper (21) from under the substrate (17),
- movement of the slide with the substrate (17).

## Revendications

1. Dispositif de traitement, en particulier de gravure et/ou de développement de substrats (17), en particulier de plaquettes, comportant
un plateau tournant (27), dans lequel le plateau tournant (27) comporte une fente Venturi (31) et le plateau tournant (27) comporte une forme de moule, dans lequel le plateau tournant (27) comprend un chanfrein (28), dans lequel le chanfrein (28) est fixé dans une partie inférieure (30),
**caractérisé en ce**
**que** le chanfrein (28) est fixé sur un bord périphérique supérieur du plateau tournant (27).

2. Dispositif selon la revendication 1, **caractérisé par** une source de milieu de pression.

3. Dispositif selon l'une quelconque des revendications précédentes, **caractérisé par** au moins un trou (13), lequel est conçu pour évacuaer un milieu de pression.

4. Dispositif selon l'une quelconque des revendications précédentes, **caractérisé par** un diffuseur (5), lequel est inséré dans le plateau tournant (1) et lequel forme la fente Venturi (3).

5. Dispositif selon l'une quelconque des revendications précédentes, **caractérisé en ce que** le plateau tournant (26) présente une pluralité de rainures (18, 19, 20) sur son bord extérieur (25).

6. Dispositif selon l'une quelconque des revendications précédentes, **caractérisé par** une pince (21) comportant une pluralité de broches de levage (22, 23, 24).

7. Procédé pour un dispositif selon les revendications 1 à 6 **caractérisé par** les étapes suivantes :
- la mise en place d'un substrat (17) sur le plateau tournant (26),
- l'exposition de la fente Venturi (3) à un milieu de pression,
- la rotation du substrat (17) au moyen du plateau tournant (26),
- l'application d'un milieu de traitement sur le substrat (17),
- le retrait du substrat (17).

8. Procédé selon la revendication 7, **caractérisé en ce que** l'étape de mise en place du substrat (17) comprend les étapes suivantes :
- le positionnement du substrat (17) sur un coulisseau ;
- le déplacement du coulisseau de telle sorte que le substrat (17) est positionné au-dessus du plateau tournant (26),
- le positionnement d'une pince (21) sous le substrat (17) de telle sorte que le substrat (17) repose sur trois broches de levage (22, 23, 24) de la pince (21),
- l'enlèvement du coulisseau sous le substrat (17),
- le dépôt du substrat (17) sur le plateau tournant (26) par un mouvement relatif entre le plateau tournant (26) et la pince (21) le long d'un axe de rotation (D) du plateau tournant (26), dans lequel les broches de levage (22, 23, 24) de la pince (21) viennent en prise dans les rainures (18, 19, 20) du plateau tournant (26).

9. Procédé selon la revendication 7, **caractérisé en ce que** l'étape de retrait d'un substrat (17) comprend les étapes suivantes :
- le positionnement d'une pince (21) sous le substrat (17) sur le plateau tournant (26),
- l'exécution d'un mouvement relatif entre le plateau tournant (26) et la pince (21) le long d'un axe de rotation (D) du plateau tournant (26), dans lequel les broches de levage (22, 23, 24) de la pince (21) viennent en prise dans les rainures (18, 19, 20) du plateau tournant (26) de telle sorte que le substrat (17) repose sur trois points de la pince (21),
- le positionnement du coulisseau sous le substrat (17),
- l'enlèvement de la pince (21) sous le substrat (17),
- le déplacement du coulisseau avec le substrat (17).
